# EUROPEAN PATENT APPLICATION

(11) **EP 2 711 143 A2**
(43) Date of publication of application: **26.03.2014**
(21) Application number: 13182350.2
(22) Date of filing: 30.08.2013
(51) Int. Cl.: B25J 9/16

(54) **Robot system and article manufacturing method**

(30) Priority: 20.09.2012 JP 2012207037
(71) Applicant: Kabushiki Kaisha Yaskawa Denki, Kitakyushu-shi, Fukuoka 806-0004 (JP)
(72) Inventor: Shimono, Toshiaki, Kitakyushu-shi, Fukuoka 806-0004 (JP)
(74) Representative: Viering, Jentschura & Partner Patent- und Rechtsanwälte

(57) **Abstract**

A robot system (100) includes a controller (14a) that performs control such that corner portions (311a to 311d) of a glass substrate (311), which is different in size from a reference glass substrate (301), are detected by cameras (2) in a state in which the glass substrate (311) is held and shifted by an end effecter (13) of a robot arm (12).

## Description

### BACKGROUND OF THE INVENTION

### 1. Field of the Invention

The present invention relates to a robot system and an article manufacturing method.

### 2. Description of the Related Art

For example, Japanese Unexamined Patent Application Publication No. 2011-40474 discloses a glass-substrate position specifying apparatus including cameras (detector) fixedly provided to detect vertexes (portions to be detected) of a glass substrate (workpiece). In this glass-substrate position specifying apparatus, four cameras are provided at positions corresponding to four vertexes (corner portions) of a rectangular glass substrate in a work station where the glass substrate is placed. On the basis of images of portions near the four vertexes of the glass substrate taken by the cameras, the coordinates of the vertexes are detected, and the position and orientation of the glass substrate are calculated from the detected coordinates of the vertexes.

However, the four cameras are fixedly provided in the glass-substrate position specifying apparatus described in the above publication. Hence, when there are a plurality of kinds of glass substrates having different sizes, vertexes of a glass substrate (workpiece) sometimes deviate from the fields of view of the cameras according to the size of the glass substrate. As a result, all of the four vertexes are sometimes not detected.

### SUMMARY OF THE INVENTION

The present disclosure has been made to address the above-described problem, and an object of the disclosure is to provide a robot system and an article manufacturing method that can reliably detect a detected portion of a workpiece by a fixedly provided detector even when there are a plurality of workpieces having different sizes.

According to a first aspect of the disclosure, there is provided a robot system including a detector that is fixedly provided to detect a detected portion of a workpiece, a robot arm equipped with a holder that holds the workpiece, and a workpiece detection control unit that performs control such that, when a detected portion of a second workpiece having a size different from a reference size of a first workpiece, of the workpiece, is detected, the detected portion of the second workpiece is detected by the detector in a state in which the second workpiece is held and shifted by the holder of the robot arm.

As described above, the robot system according to the first aspect includes the workpiece detection control unit that performs control such that, when the detected portion of the second workpiece having a size different from the reference size of the first workpiece is detected, the detected portion of the second workpiece is detected by the detector in the state in which the second workpiece is held and shifted by the holder of the robot arm. Thus, even when it is difficult to detect the detected portion of the second workpiece by the fixedly provided detector, it can be detected by the detector because the second workpiece is shifted. As a result, even when there are a plurality of kinds of workpieces having different sizes, a detected portion of a workpiece can be reliably detected by the fixedly provided detector.

According to a second aspect of the disclosure, there is provided an article manufacturing method including transporting a workpiece, and detecting, by a detector, a detected portion of a second workpiece having a size different from a reference size of a first workpiece, of the transported workpiece, in a state in which the second workpiece is held and shifted by a holder of a robot arm.

As described above, the article manufacturing method according to the second aspect includes detecting, by the detector, the detected portion of the second workpiece having a size different from the reference size of the first workpiece in the state in which the second workpiece is held and shifted by the holder of the robot arm. Thus, even when it is difficult to detect the detected portion of the second workpiece by the fixedly provided detector, it can be detected by the detector because the second workpiece is shifted. As a result, even when there are a plurality of kinds of workpieces having different sizes, a detected portion of a workpiece can be reliably detected by the fixedly provided detector.

The above configurations allow a detected portion of a workpiece to be reliably detected by the fixedly provided detector even when there are a plurality of kinds of workpieces having different sizes.

### BRIEF DESCRIPTION OF THE DRAWINGS

Fig. 1 is a general view of a robot system according to a first embodiment.

Fig. 2 is a top view of the robot system of the first embodiment.

Fig. 3 is a top view of a glass substrate (reference substrate) having a reference size.

Fig. 4 is a top view of a glass substrate (non-reference substrate) having a size different from the reference size.

Fig. 5 is a perspective view of an end effecter in the robot system of the first embodiment.

Fig. 6 is a block diagram of the robot system of the first embodiment.

Fig. 7 is a perspective view of a trimming device in the robot system of the first embodiment.

Fig. 8 is a flowchart illustrating an operation of trimming a reference substrate in the robot system of the first embodiment.

Fig. 9 is a side view of the reference substrate located at a reference position.

Fig. 10 illustrates a state in which a substrate is being transported by a robot arm in the robot system of the first embodiment.

Fig. 11 illustrates an operation of trimming the substrate from a side portion toward a corner portion in the robot system of the first embodiment.

Fig. 12 illustrates an operation of trimming the substrate from the corner portion toward the side portion in the robot system of the first embodiment.

Fig. 13 is a flowchart illustrating an operation of trimming a non-reference substrate in the robot system of the first embodiment.

Fig. 14 is a top view illustrating a state in which the non-reference substrate is placed on a conveyor.

Fig. 15 is a side view of the non-reference substrate located at the reference position.

Fig. 16 is a top view of the non-reference substrate shifted from the reference position.

Fig. 17 is a side view of the non-reference substrate shifted from the reference position.

Fig. 18 is a top view illustrating a state in which a non-reference substrate is placed on a conveyor in a second embodiment.

Fig. 19 is a top view of the non-reference substrate shifted from a reference position in the second embodiment.

Fig. 20 is a top view illustrating a state in which a reference substrate and a non-reference substrate are placed on a conveyor in a third embodiment.

Fig. 21 is a top view of the reference substrate and the non-reference substrate moved from the state of Fig. 20.

Fig. 22 is a top view illustrating a state in which a reference substrate is placed on a conveyor in a modification of the third embodiment.

### DESCRIPTION OF THE EMBODIMENTS

Embodiments of the present disclosure will be described below with reference to the drawings.

### First Embodiment

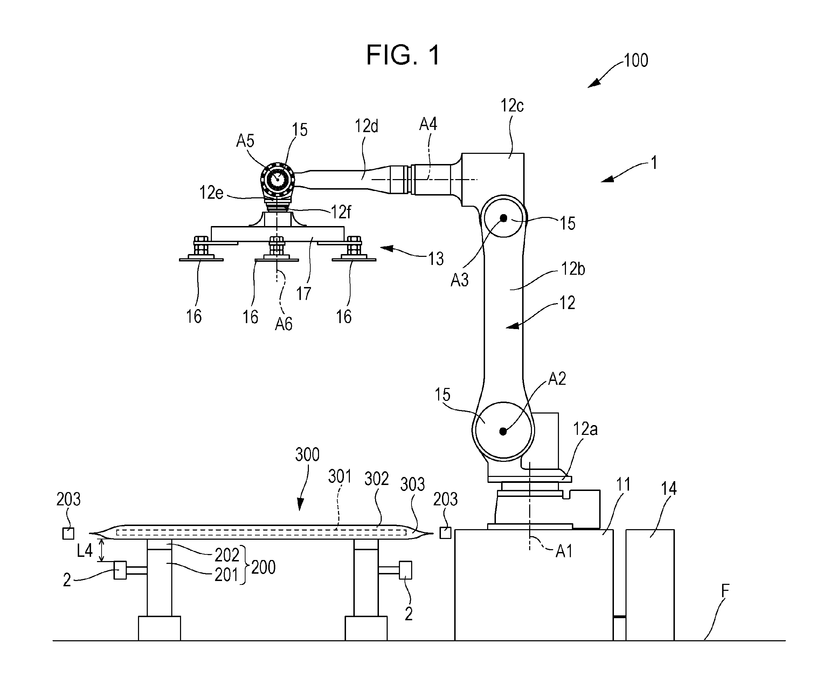

First, a configuration of a robot system 100 according to a first embodiment will be described with reference to Figs. 1 to 7.

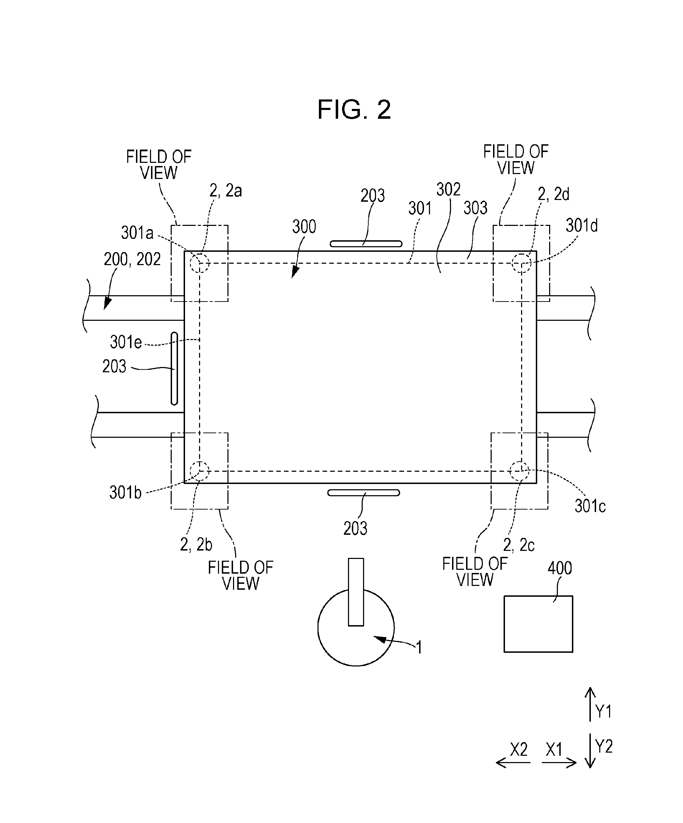

As illustrated in Figs. 1 and 2, the robot system 100 includes a robot 1 and cameras 2 attached to a conveyor 200. The robot 1 includes a base 11, a robot arm 12 mounted on the base 11, an end effecter 13 attached to a distal end of the robot arm 12, and a robot controller 14 that controls the general operation of the robot 1. The conveyor 200 is provided adjacent to the robot 1 to transport a substrate 300. As illustrated in Fig. 2, a trimming device 400 is provided adjacent to the robot 1 to trim below-described protruding portions 303 of the substrate 300. The cameras 2 serve as an example of a "detector", and the end effecter 13 serves as an example of a "holder."

The conveyor 200 includes stands 201, and roller units 202 provided on the stands 201 to move the substrate 300. As illustrated in Fig. 2, the conveyor 200 also includes stoppers 203 that roughly position the substrate 300. One stopper 203 is provided on a transport direction side (a side of arrow X2) of the substrate 300, and two stoppers 203 are provided on sides (sides of arrows Y1 and Y2) orthogonal to the transport direction side of the substrate 300.

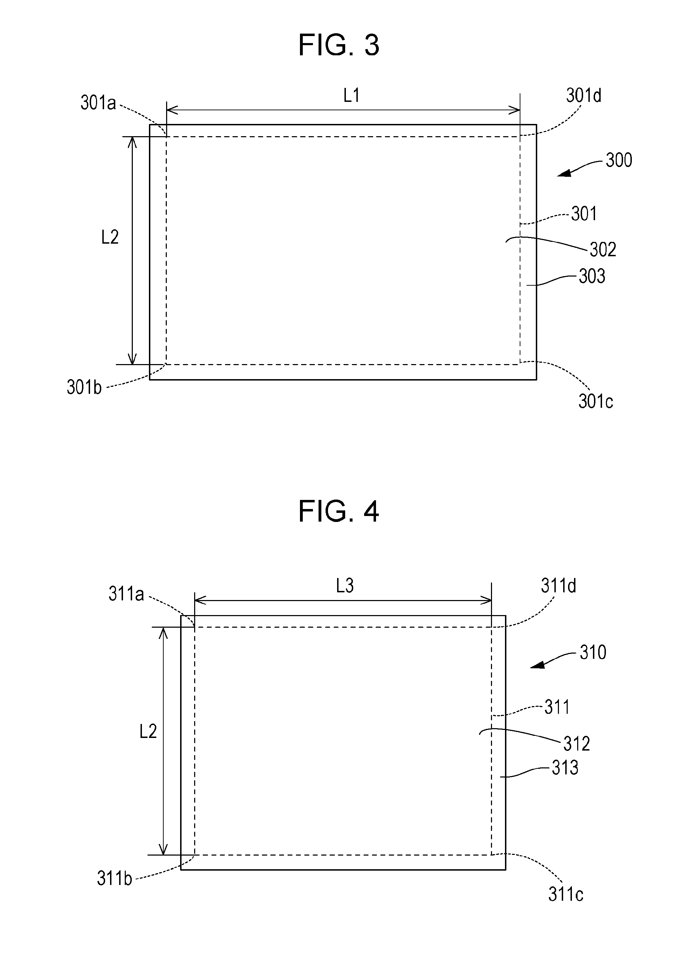

As illustrated in Fig. 3, the substrate 300 (reference substrate) includes a glass substrate 301, and a sheet-like member 302 formed by lamination to cover the glass substrate 301. The sheet-like member 302 is formed to include protruding portions 303 that protrude out from four sides of the glass substrate 301. The glass substrate 301 may be substantially rectangular and may have four corner portions 301a, 301b, 301c, and 301d. The glass substrate 301 has a size serving as a reference size, and has a length L1 in a longitudinal direction and a length L2 in a lateral direction.

As illustrated in Fig. 4, a substrate 310 (non-reference substrate) includes a glass substrate 311 and a sheet-like member 312 formed by lamination to cover the glass substrate 311. The sheet-like member 312 is formed to have protruding portions 313 that protrudes out from four sides of the glass substrate 311. The glass substrate 311 may be substantially rectangular, and may have four corner portions 311a, 311b, 311c, and 311d. The glass substrate 311 has a size different from the reference size of the glass substrate 301. Specifically, a length L3 in a longitudinal direction of the glass substrate 311 is less than the length L1 in the longitudinal direction of the glass substrate 301 (L3 < L1), and a length L2 in a lateral direction of the glass substrate 311 is equal to the length L2 in the lateral direction of the glass substrate 301. The glass substrate 301 serves as an example of a "workpiece" and a "first workpiece." The corner portions 311a and 311b serve as an example of a "detected portion" and a "first detected portion", and the corner portions 311c and 311d serve as an example of a "detected portion" and a "second detected portion".

As illustrated in Fig. 1, the base 11 is fixed to an installation surface F such as a floor, a wall, or a ceiling. In the first embodiment, the robot arm 12 has six degrees of freedom, and includes a plurality of arm structures. An arm structure 12a is connected to the base 11 to be rotatable about a rotation shaft A1 perpendicular to the installation surface F. An arm structure 12b is connected to the arm structure 12a to be rotatable about a rotation shaft A2 perpendicular to the rotation shaft A1. An arm structure 12c is connected to the arm structure 12b to be rotatable about a rotation shaft A3 parallel to the rotation shaft A2. An arm structure 12d is connected to the arm structure 12c to be rotatable about a rotation shaft A4 perpendicular to the rotation shaft A3. An arm structure 12e is connected to the arm structure 12d to be rotatable about a rotation shaft A5 perpendicular to the rotation shaft A4. An arm structure 12f is connected to the arm structure 12e to be rotatable about a rotation shaft A6 perpendicular to the rotation shaft A5. Here, the terms "parallel" and "perpendicular" are not strictly defined, and they may include "substantially parallel" and "substantially perpendicular", respectively. The rotation shafts A1 to A6 have respective servo motors (joints 15), and the servo motors include encoders for detecting the rotation positions thereof. The servo motors are connected to the robot controller 14, and are operated according to instructions from the robot controller 14.

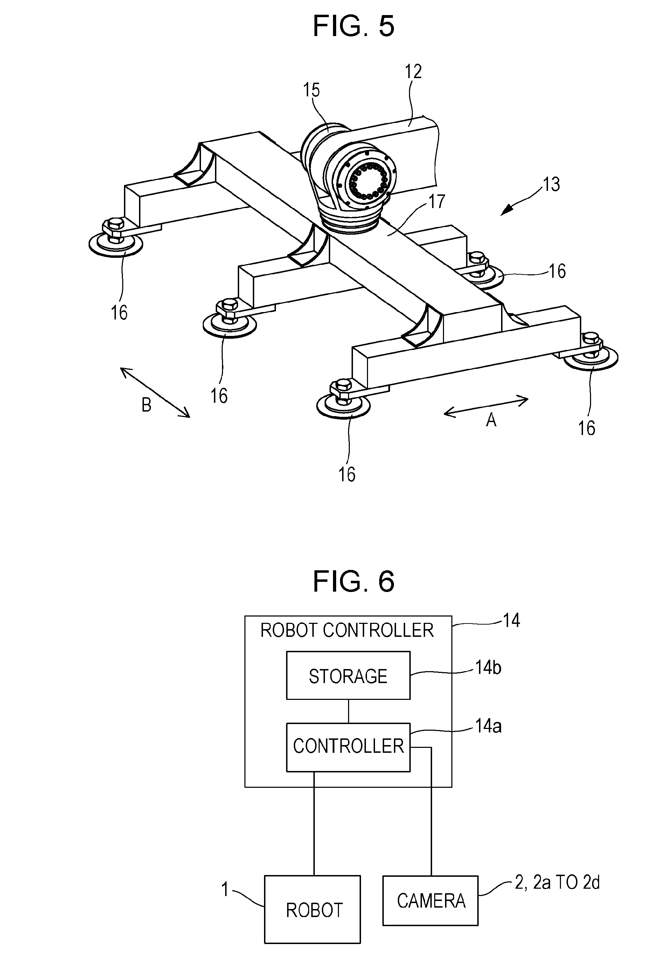

As illustrated in Fig. 5, the end effecter 13 includes six suction parts 16 for sucking and holding the substrate 300, and an attachment part 17 to which the six suction parts 16 are attached. The suction parts 16 are arranged in a matrix of two (in an A-direction) by three (in a B-direction) (six in total (= 2×3)).

As illustrated in Fig. 2, four cameras 2 (cameras 2a to 2d) are provided. In the first embodiment, in plan view, cameras 2a and 2b are located at positions corresponding to the corner portions 301a and 301b on one side of the substantially rectangular glass substrate 301 having the reference size, and cameras 2c and 2d are located at positions corresponding to the corner portions 301c and 301d on the other side of the glass substrate 301. Specifically, the four cameras 2a to 2d are provided such that the corner portions 301a to 301d of the substantially rectangular glass substrate 301 of the reference size are located within fields of view of the four cameras 2a to 2d (for example, ranges having an area of about 200 mm by about 300 mm, see one-dot chain lines in Fig. 2). Also, the four cameras 2a to 2d may be fixedly provided at positions a predetermined distance L4 (for example, about 280 mm, see Fig. 1) below a position on the conveyor 200 where the substrate 300 is to be placed. The cameras 2a and 2b serve as an example of a "detector" and a "first detector part" and the cameras 2c and 2d serve as an example of a "detector" and a "second detector part."

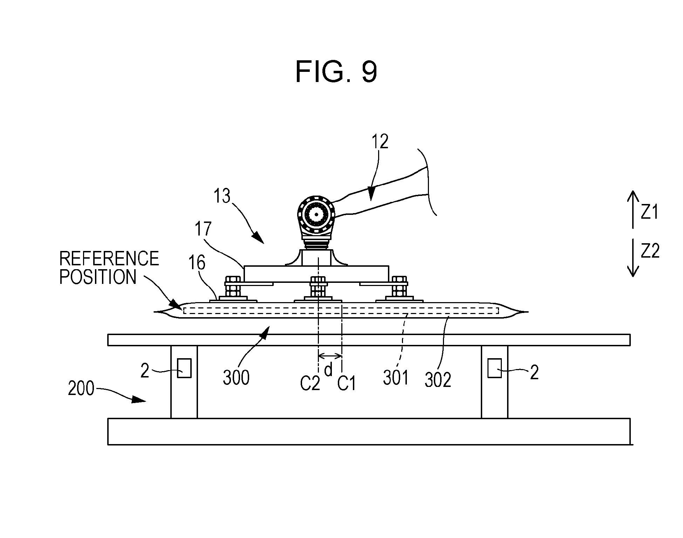

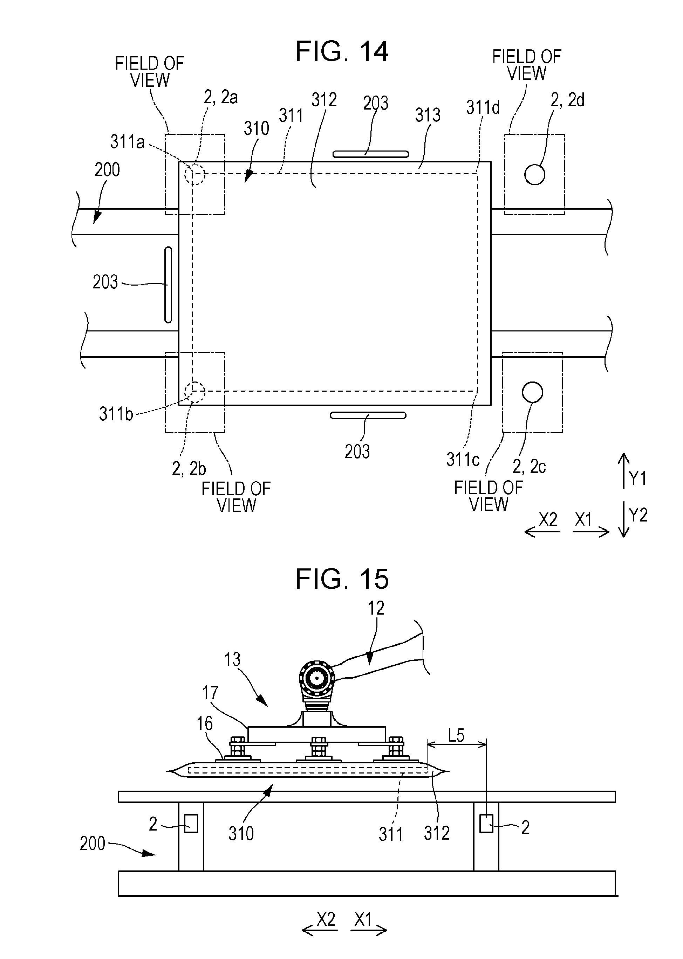

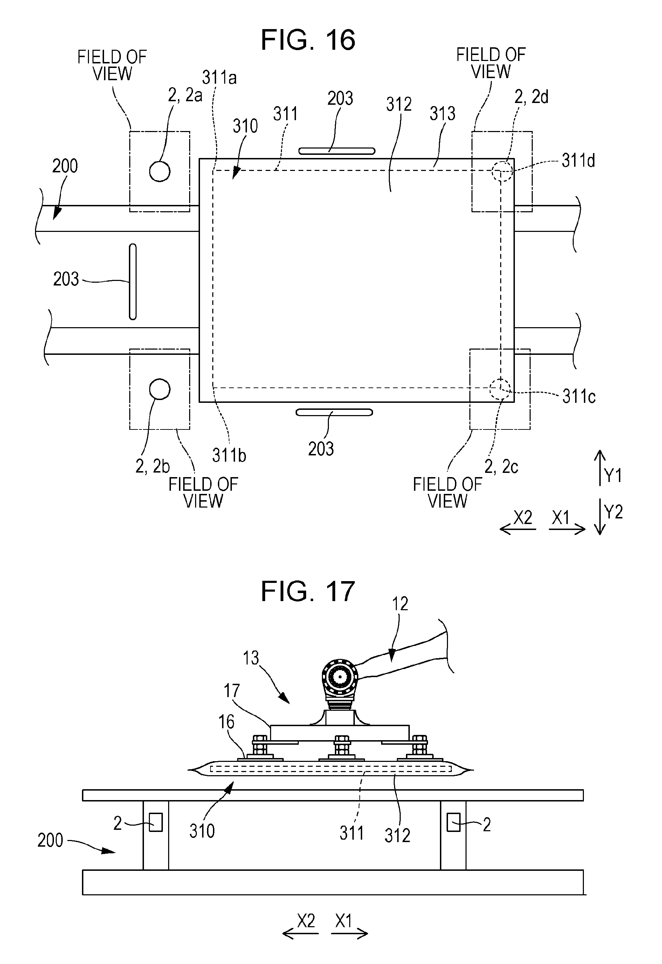

As illustrated in Fig. 6, the robot controller 14 includes a controller 14a and a storage 14b. The storage 14b is connected to the controller 14a. Also, the four cameras 2 are connected to the controller 14a. In the first embodiment, the controller 14a may be configured such that the four corner portions 301a to 301d of the glass substrate 301 of the reference size are photographed (detected) by the cameras 2a and 2d, respectively, in a state in which the glass substrate 301 is located at a reference position (see Fig. 9). The reference position refers to a position of the glass substrate 301 such that the corner portions 301a and 301b of the glass substrate 301 (a side 301e between the corner portions 301a and 301b, see Fig. 2) are located above the cameras 2a and 2b (on a side of arrow Z1). The controller 14a may be configured such that, when the corner portions 311a to 311d of the glass substrate 311 having a size different from that of the glass substrate 301 are photographed, the corner portions 311a and 311b are photographed by the cameras 2a and 2b, respectively, in a state in which the glass substrate 311 is located at the reference position (see Fig. 15) and the corner portions 311c and 311d of the glass substrate 311 are photographed by the cameras 2c and 2d, respectively, in a state in which the glass substrate 311 is held and shifted from the reference position by the end effecter 13 of the robot arm 12 (see Fig. 17). The glass substrate 311 serves as an example of a "workpiece" and a "second workpiece", the controller 14a serves as an example of a "workpiece detection control unit" and a "workpiece transport instruction unit", and the storage 14b serves as an example of a "storage unit."

In the first embodiment, the storage 14b may prestore the sizes of the glass substrate 301 and the glass substrate 311. Specifically, the storage 14b stores the length L1 in the longitudinal direction and the length L2 in the lateral direction of the glass substrate 301 and the length L3 in the longitudinal direction and the length L2 in the lateral direction of the glass substrate 311.

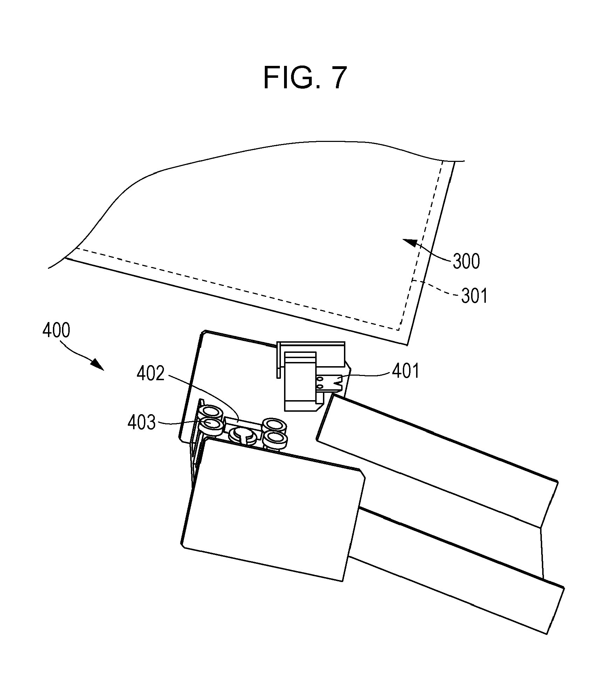

As illustrated in Fig. 7, the trimming device 400 includes a cutter blade 401 and a cutter blade 402 for trimming protruding portions 303 (313) of the sheet-like member 302 (312) that protrude out from four sides of the glass substrate 301 (311). Around the cutter blade 402, rollers 403 are provided to guide the substrate 300 (310).

Next, a description will be given of an operation of the robot system 100 for trimming a substrate 300 (reference substrate) including a glass substrate 301 of the reference size, with reference to Figs. 2 and 8 to 12.

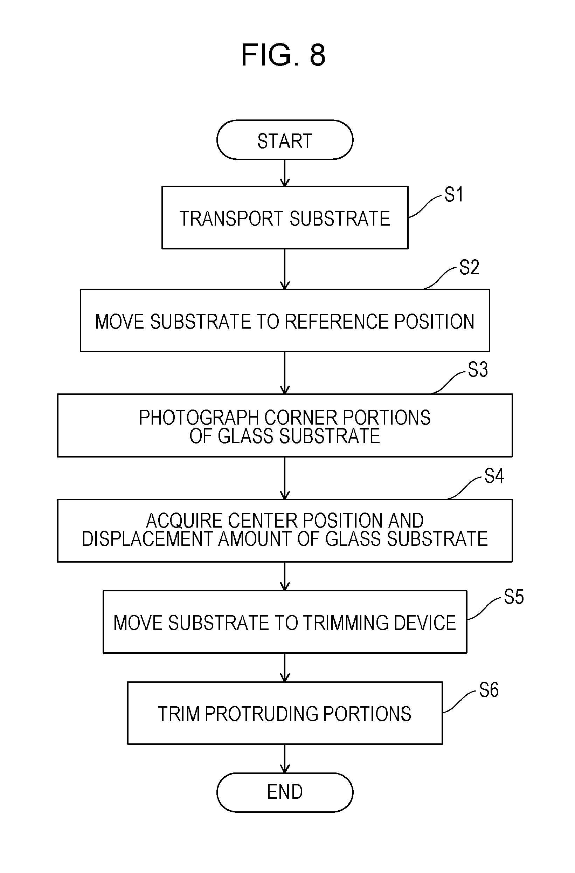

First, as illustrated in Fig. 8, in Step S1, a substrate 300 is transported by the conveyor 200 from the side of arrow X1 toward the side of arrow X2, as illustrated in Fig. 2. The substrate 300 is transported by the conveyor 200 so that corner portions 301a to 301d of a glass substrate 301 are located in the fields of view of the four cameras 2a to 2d, respectively.

Next, as illustrated in Fig. 9, in Step S2, the substrate 300 is held (sucked) and lifted up (moved) in the direction of arrow Z1 by the end effecter 13 of the robot arm 12, and is placed at the reference position. After that, in Step S3, the corner portions 301a to 301d of the glass substrate 301 are photographed by the cameras 2a to 2d, respectively.

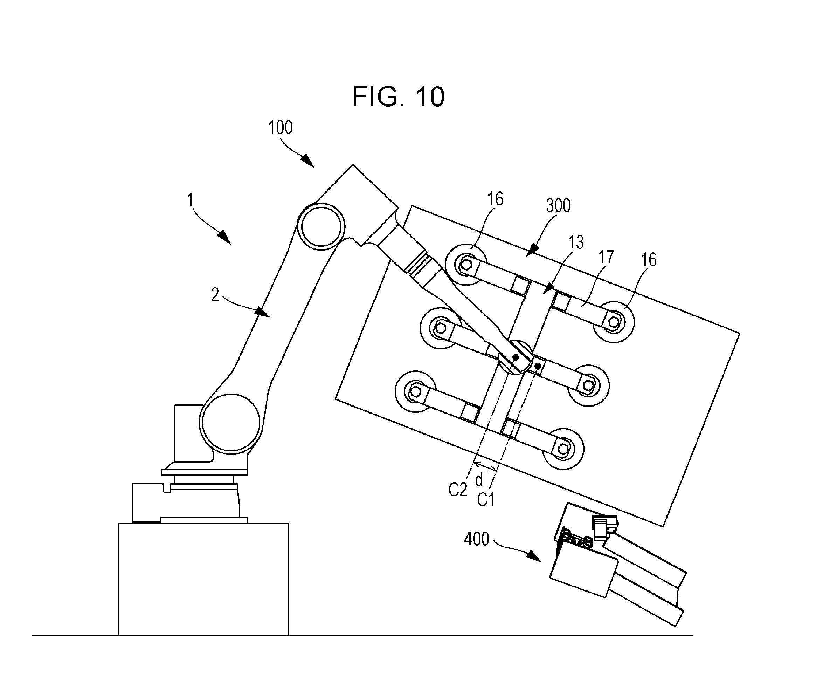

Next, in the first embodiment, in Step S4, a center position C1 of the glass substrate 301 (see Figs. 9 and 10) may be acquired (calculated) on the basis of images of the corner portions 301a to 301d of the glass substrate 301 taken by the cameras 2a to 2d. Further, a displacement amount d between the acquired center position C1 of the glass substrate 301 and a position C2 on the glass substrate 301 corresponding to the center position of the end effecter 13 of the robot arm 12 is acquired (calculated). Even when the glass substrate 301 is inclined with respect to the transport direction (direction of arrow X, see Fig. 2), the center position C1 of the glass substrate 301 can be acquired on the basis of the images of the four corner portions 301a to 301d.

Next, as illustrated in Fig. 10, in Step S5, the glass substrate 301 may be transported to a trimming position of the trimming device 400 according to the displacement amount d between the center position C1 of the glass substrate 301 and the position C2 on the glass substrate 301 corresponding to the center position of the end effecter 13 of the robot arm 12. More specifically, the robot arm 12 is instructed to properly transport the glass substrate 301 to the trimming device 400 when it holds the glass substrate 301 so that the center position C2 of the end effecter 13 of the robot arm 12 substantially coincides with the center position C1 of the glass substrate 301. When the center position C1 of the glass substrate 301 and the position C2 on the glass substrate 301 corresponding to the center position of the end effecter 13 of the robot arm 12 do not coincide, a trajectory along which the robot arm 12 moves is corrected on the basis of the displacement amount d, and the glass substrate 301 is then transported to the trimming device 400.

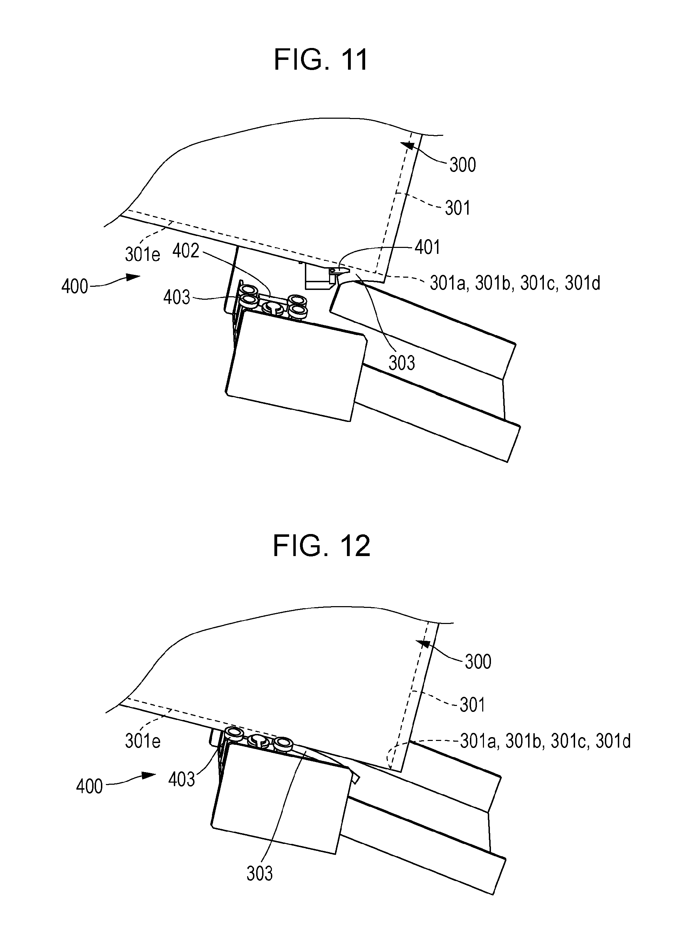

Next, in Step S6, as illustrated in Fig. 11, protruding portions 303 of a sheet-like member 302 protruding from the glass substrate 301 are trimmed from a side 301e of the glass substrate 301 toward the corner portion 301a (301b to 301d). Then, the protruding portions 303 of the sheet-like member 302 are trimmed from the corner portion 301a (301b to 301d) of the 301 toward the side 301e. When all protruding portions 303 protruding from four sides of the glass substrate 301 are trimmed, the trimming operation is completed.

Next, a description will be given of an operation of the robot system 100 for trimming a substrate 310 (non-reference substrate) including a glass substrate 311 having a size different from the size of the glass substrate 301, with reference to Figs. 10 to 17.

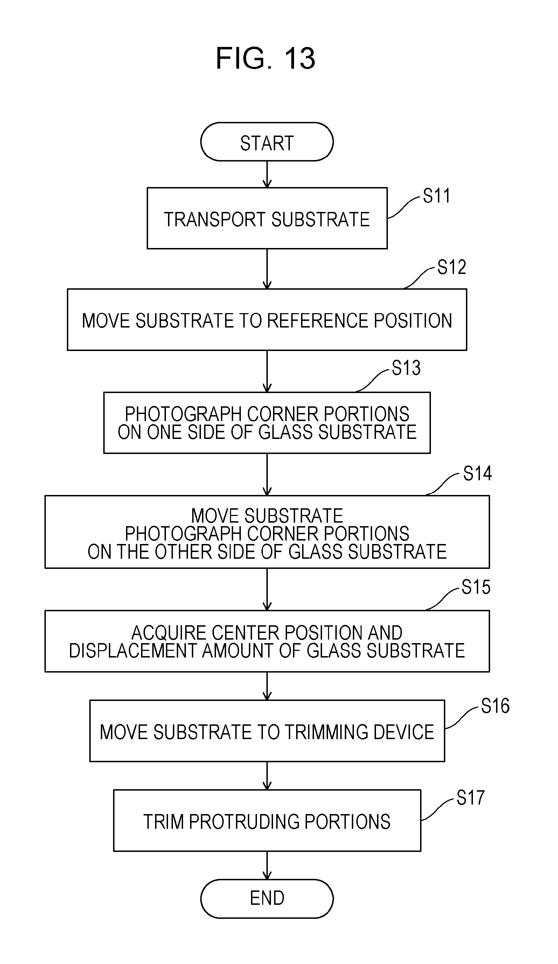

First, as illustrated in Fig. 13, in Step S11, the substrate 310 is transported by the conveyor 200 from the side of arrow X1 toward the side of arrow X2, as illustrated in Fig. 14. The substrate 310 is transported by the conveyor 200 so that corner portions 311a and 311b of the glass substrate 311 are located within the fields of view of the cameras 2a and 2b provided on the side of arrow X2, respectively.

Next, as illustrated in Fig. 15, in Step S12, the substrate 310 is held (sucked) and lifted up (moved) in the direction of arrow Z1 by the end effecter 13 of the robot arm 12, and is placed at the reference position. After that, in Step S13, the corner portions 311a and 311b on one side (side of arrow X2) of the glass substrate 311 are photographed by the cameras 2a and 2b, respectively.

Next, in the first embodiment, as illustrated in Figs. 16 and 17, in Step S14, corner portions 311c and 311d on the other side of the glass substrate 311 (side of arrow X1) are photographed by the cameras 2c and 2d, respectively, in a state in which the glass substrate 311 (substrate 310) is shifted from the reference position in the direction of arrow X1 while being held by the end effecter 13 of the robot arm 12. More specifically, the glass substrate 311 is shifted from the reference position to be located above the cameras 2c and 2d (into the fields of view of the cameras 2c and 2d). The glass substrate 311 may be shifted from the reference position in the horizontal direction while being held by the end effecter 13 of the robot arm 12.

In the first embodiment, the glass substrate 311 may be shifted from the reference position in the horizontal direction by a predetermined horizontal distance based on the size of the glass substrate 311 stored in the storage 14b while being held by the end effecter 13 of the robot arm 12. More specifically, the glass substrate 311 is shifted from the reference position in the horizontal direction by a difference L5 between the length L1 of the glass substrate 301 in the longitudinal direction and the length L2 of the glass substrate 311 in the longitudinal direction (= L1-L2, see Fig. 15).

Next, in Step S15, a center position C1 of the glass substrate 311 is acquired (calculated), and a displacement amount d between the center position C1 of the glass substrate 311 and a position C2 on the glass substrate 311 corresponding to the center position of the end effecter 13 of the robot arm 12 is acquired (calculated), similarly to Step S4 in the above-described trimming operation of the substrate 300. Then, in Step S16, as illustrated in Fig. 10, the glass substrate 311 may be transported to the trimming device 400 according to the displacement amount d between the center position C1 of the glass substrate 311 and the position C2 on the glass substrate 311 corresponding to the center position of the end effecter 13 of the robot arm 12, similarly to Step S5 in the trimming operation of the substrate 300.

Next, in Step S17, as illustrated in Figs. 11 and 12, protruding portions 313 of a sheet-like member 312 protruding from the glass substrate 311 are trimmed, and the trimming operation is completed, similarly to Step S6 in the trimming operation of the substrate 300. As described above, in the first embodiment, after the substrate 310 (glass substrate 311) is held by the end effecter 13 of the robot arm 12, the holding state of the substrate 310 is maintained. In this state, the substrate 310 is moved to the reference position, the corner portions 311a to 311d of the glass substrate 311 are detected, and the substrate 310 is transported to the trimming device 400 on the basis of the images of the corner portions 311a to 311d of the glass substrate 311 taken by the cameras 2.

As described above, the first embodiment adopts the controller 14a for performing control such that the corner portions 311c and 311d of the glass substrate 311 having the size different from the reference size of the glass substrate 301 are photographed by the cameras 2c and 2d, respectively, in the state in which the glass substrate 311 is held and shifted from the reference position by the end effecter 13 of the robot arm 12. Thus, even when the corner portions 311c and 311d of the glass substrate 311 located at the reference position are not photographed by the fixed cameras 2c and 2d, they can be photographed by the fixed cameras 2c and 2d, respectively, because the glass substrate 311 is shifted from the reference position. As a result, even when there are a plurality of sizes of the glass substrate 311, the corner portions 311c and 311d of the glass substrate 311 can be reliably photographed by the fixed cameras 2c and 2d.

In the first embodiment, as described above, the controller 14a is configured such that the corner portions 311c and 311d of the glass substrate 311 are photographed by the cameras 2c and 2d in the state in which the glass substrate 311 is held and shifted from the reference position in the horizontal direction by the end effecter 13 of the robot arm 12. Thus, the glass substrate 311 is moved while maintaining the vertical distance (object distance) between the cameras 2c and 2d and the glass substrate 311, unlike the case in which the glass substrate 311 is moved from the reference position in the vertical direction or an oblique direction. As a result, the corner portions 311c and 311d of the glass substrate 311 can be photographed without adjusting the vertical distance between the cameras 2c and 2d and the glass substrate 311 after movement.

In the first embodiment, as described above, the controller 14a is configured such that the corner portions 311a and 311b of the glass substrate 311 are photographed by the cameras 2a and 2b in the state in which the glass substrate 311 is located at the reference position and such that the corner portions 311c and 311d of the glass substrate 311 are photographed by the cameras 2c and 2d in the state in which the glass substrate 311 is held and shifted from the reference position by the end effecter 13 of the robot arm 12. Thus, all of the corner portions 311a to 311d of the glass substrate 311 can be photographed without moving the cameras 2a to 2d. As a result, all of the corner portions 311a to 311d of the glass substrate 311 can be photographed without performing calibration of the cameras 2a to 2d (without readjusting the photographing conditions), unlike the case in which the cameras 2a to 2d are moved.

In the first embodiment, as described above, the controller 14a is configured such that the corner portions 301a to 301d of the glass substrate 301 having the reference size are photographed by the cameras 2a to 2d in the state in which the glass substrate 301 is held and moved to the reference position by the end effecter 13 of the end effecter 13. Thus, all of the corner portions 301a to 301d of the glass substrate 301 can be photographed without holding and moving the glass substrate 301 in the horizontal direction by the end effecter 13 of the robot arm 12. Hence, the takt time of the operation of photographing the corner portions 301a to 301d of the glass substrate 301 can be made shorter than when all of the corner portions 301a to 301d are photographed while the glass substrate 301 is being held and moved in the horizontal direction by the end effecter 13 of the robot arm 12.

In the first embodiment, as described above, the cameras 2a to 2d are fixedly provided at the positions a predetermined distance L4 below the position of the glass substrate 301 (glass substrate 311) on the conveyor 200. This allows the corner portions 301a to 301d (corner portions 311a to 311d) of the glass substrate 301 (glass substrate 311) located above the cameras 2a to 2d to be photographed easily.

In the first embodiment, as described above, the controller 14a is configured such that the center position C1 of the glass substrate 301 is acquired on the basis of the photographing results of the corner portions 301a to 301d of the glass substrate 301 (glass substrate 311) taken by the cameras 2a to 2d and such that the glass substrate 301 is transported to the trimming position (trimming device 400) on the basis of the displacement amount d between the acquired center position C1 of the glass substrate 301 and the position C2 on the glass substrate 301 corresponding to the center position of the end effecter 13 of the robot arm 12. Thus, even when the center position C1 of the glass substrate 301 does not coincide with the position C2 on the glass substrate 301 corresponding to the center position of the end effecter 13 of the robot arm 12, the glass substrate 301 can be easily and accurately transported to the trimming position of the trimming device 400.

In the first embodiment, as described above, the controller 14a is configured such that, after the glass substrate 311 is held by the end effecter 13 of the robot arm 12, in the state in which the holding state of the glass substrate 311 is maintained, the glass substrate 311 is moved to the reference position, the corner portions 311a to 311d of the glass substrate 311 are photographed, and the glass substrate 311 is transported to the trimming position on the basis of the photographing results of the corner portions 311a to 311d of the glass substrate 311 photographed by the cameras 2a to 2d. Thus, displacement of the holding position of the glass substrate 311 can be suppressed, unlike the case in which the holding state of the glass substrate 311 is cancelled (for example, the glass substrate 311 is placed on the conveyor 200) every time the glass substrate 311 is moved and photographed. As a result, the glass substrate 311 can be more accurately transported to the trimming position.

In the first embodiment, as described above, the controller 14a is configured such that the corner portions 311a to 311d of the glass substrate 311 are photographed by the cameras 2a to 2d in the state in which the glass substrate 311 is held and shifted from the reference position in the horizontal direction by the predetermined horizontal distance by the end effecter 13 of the robot arm 12 on the basis of the size of the glass substrate 311 stored in the storage 14b. Thus, the takt time of the operation of photographing and transporting the glass substrate 311 can be made shorter than when the size of the glass substrate 311 transported by the conveyor 200 is measured and it is determined whether or not the glass substrate 311 is to be held and shifted from the reference position by the predetermined horizontal distance.

### Second Embodiment

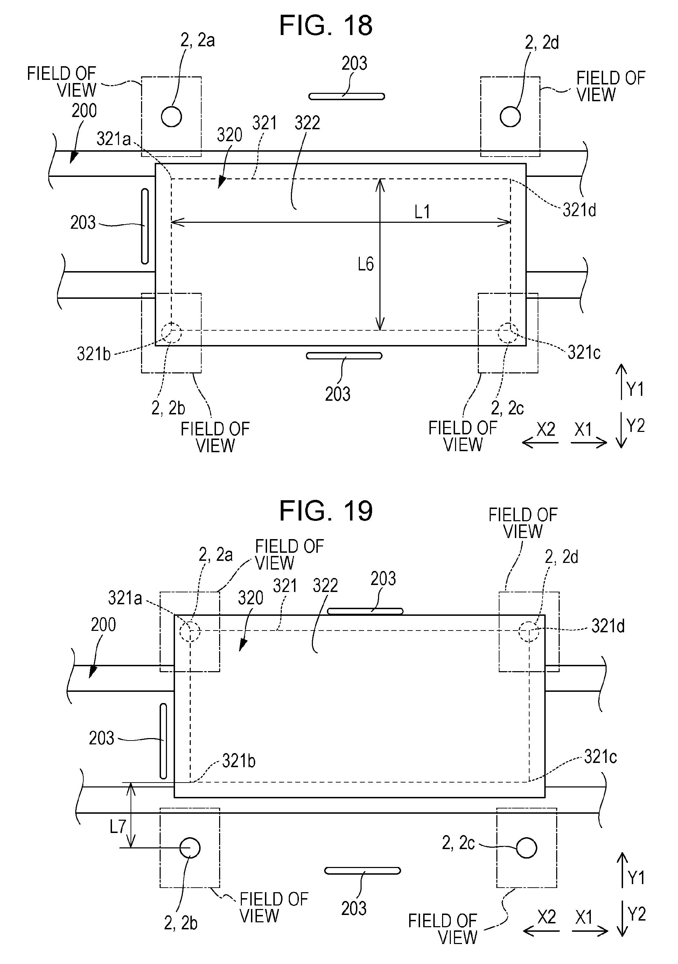

Next, a robot system 100 according to a second embodiment will be described with reference to Fig. 18. In the second embodiment, a glass substrate 321 having a length L6 in the lateral direction different from that of a glass substrate 301 having a reference size is transported by a conveyor 200.

As illustrated in Fig. 18, a substrate 320 includes a glass substrate 321 and a sheet-like member 322 formed by lamination to cover the glass substrate 321. The glass substrate 321 is substantially rectangular, and includes four corner portions 321a, 321b, 321c, and 321d. Further, the glass substrate 321 has a size different from a reference size of a glass substrate 301. More specifically, a length L1 of the glass substrate 321 in the longitudinal direction is equal to a length L1 of the glass substrate 301 in the longitudinal direction, and a length L6 of the glass substrate 321 in the lateral direction is less than a length L2 of the glass substrate 301 in the lateral direction (L6 < L2). The glass substrate 321 serves as an example of a "workpiece" and a "second workpiece." The corner portions 321b and 321c serve as an example of a "detected portion" and a "first detected portion", and the corner portions 321a and 321d serve as an example of a "detected portion" and a "second detected portion." Further, cameras 2b and 2c serve as an example of a "detector" and a "first detector part", and cameras 2a and 2d serve as an example of a "detector" and a "second detector part."

Next, an operation of the robot system 100 for trimming a substrate 320 will be described with reference to Figs. 13, 18, and 19.

First, as illustrated in Fig. 13, in Step S11, a substrate 320 is transported by a conveyor 200 from a side of arrow X1 toward a side of arrow X2. Next, in Step S12, as illustrated in Fig. 18, the substrate 320 is held (sucked) and lifted up (moved) in a direction of arrow Z1 by an end effecter 13 of a robot arm 12, and is placed at a reference position. After that, in Step S13, corner portions 321b and 321c of the glass substrate 321 on a side of arrow Y2 are photographed by the cameras 2b and 2c, respectively.

Next, in Step S14, as illustrated in Fig. 19, the glass substrate 321 (substrate 320) is shifted from the reference position toward a side of arrow Y1 while being kept held by the end effecter 13 of the robot arm 12. In this state, corner portions 321a and 321d of the glass substrate 321 on the side of arrow Y1 are photographed by the cameras 2a and 2d, respectively. More specifically, the substrate 320 is shifted from the reference position in the horizontal direction by an amount corresponding to a difference L7 between the length L2 of the glass substrate 301 in the lateral direction and the length L6 of the glass substrate 321 in the lateral direction (= L2-L6).
Subsequent operations (Steps S15 to S17) are similar to those adopted in the above-described first embodiment.

### Third Embodiment

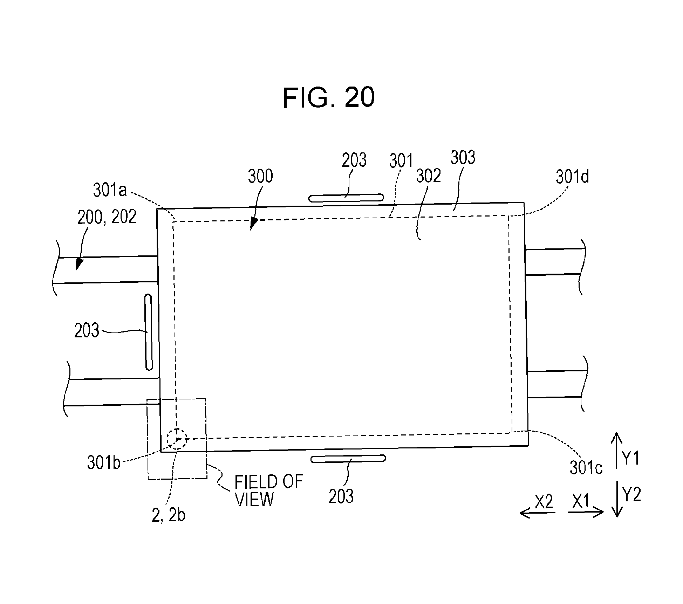

Next, a robot system 100 according to a third embodiment will be described with reference to Fig. 20. In the third embodiment, one camera 2b may be provided on a conveyor 200, unlike the above-described first and second embodiments in which four cameras 2 are provided on the conveyor 200.

As illustrated in Fig. 20, in the third embodiment, one camera 2b is provided at a position corresponding to a corner portion 301b on a side of arrow X2 and a side of arrow Y2 of a substantially rectangular glass substrate 301. Other structures in the third embodiment are similar to those adopted in the above-described first and second embodiments.

A trimming operation of the robot system 100 of the third embodiment will be described with reference to Figs. 8 and 20.

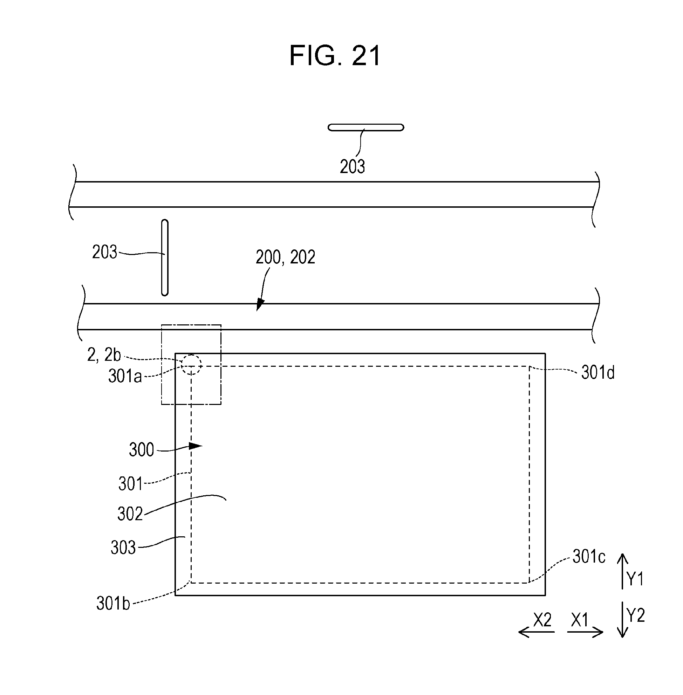

An operation of transporting a substrate 300 in Step S1 and an operation of moving the substrate 300 to a reference position in Step S2 in Fig. 8 are similar to those performed in the first embodiment. In the third embodiment, in Step S3, one corner portion 301b, of four corner portions of a substantially rectangular glass substrate 301, is photographed by the camera 2b in a state in which the glass substrate 301 (substrate 300) is located at the reference position. Further, the substrate 300 (glass substrate 301) may be held by an end effecter 13 of a robot arm 12 and may be sequentially moved to positions where corner portions 301a, 301c, and 301d can be detected by the camera 2b, so that the remaining corner portions 301a, 301c, and 301d of the glass substrate 301 are photographed by the camera 2b. For example, after the substrate 300 (glass substrate 301) is moved toward a side of arrow Y2 from the state of Fig. 20 by the end effecter 13 of the robot arm 12, as illustrated in Fig. 21, the corner portion 301a is photographed by the camera 2b. Further, after the substrate 300 (glass substrate 301) is moved toward a side of arrow X2 by the end effecter 13 of the robot arm 12, the corner portion 301d is photographed by the camera 2b. Subsequently, the substrate 300 (glass substrate 301) is moved toward a side of arrow Y1, and the corner portion 301c is photographed by the camera 2b. After that, Steps S4 to S6 are performed.

In a trimming operation for a substrate having a size different from the reference size (for example, a glass substrate 311, see Fig. 4), one of the four corner portions of a substantially rectangular glass substrate (for example, a corner portion 311b) is photographed by the camera 2b in a state in which the glass substrate is located at the reference position. After that, the substrate (glass substrate) is held and shifted by distances different from the distances for the corner portions 301a, 301c, and 301d of the glass substrate 301 of the reference size by the end effecter 13 of the robot arm 12. In this state, the remaining corner portions (for example, corner portions 311a, 311c, and 311d) of the glass substrate 301 are photographed. Other operations in the third embodiment are similar to those adopted in the first embodiment.

In the third embodiment, as described above, the single camera 2b is provided at the position corresponding to the corner portion 301b on one side (the side of arrow X2) of the substantially rectangular glass substrate 301, and the controller 14a is configured such that the corner portion 301b of the four corner portions 301a to 301d of the substantially rectangular glass substrate 301 is photographed by the camera 2b in a state in which the glass substrate 301 is located at the reference position and such that the remaining corner portions 301a, 301c, and 301d of the glass substrate 301 are photographed by the camera 2b while holding and sequentially moving the glass substrate 301 to the positions, where the corner portions 301a, 301c, and 301d can be photographed by the camera 2b, by the end effecter 13 of the robot arm 12. Since this can reduce the number of cameras 2, the configuration of the robot system 100 can be simplified.

It should be noted that the embodiments disclosed here are just exemplary in all respects, but are not restrictive. It should be understood by those skilled in the art that various modifications, combinations, subcombinations and alterations may occur depending on design requirements and other factors insofar as they are within the scope of the appended claims or the equivalents thereof.

While the portions of the sheet-like member protruding from the substantially rectangular glass substrate are trimmed in the above-described first to third embodiments, for example, a portion of a sheet-like member protruding from a semiconductor substrate different from the glass substrate may be trimmed.

While the corner portions of the substantially rectangular glass substrate are photographed (detected) by the cameras or the camera in the first to third embodiments, for example, portions of a glass substrate that is not substantially rectangular may be photographed (detected).

While the corner portions of the glass substrate are photographed (detected) by the cameras or the camera in the first to third embodiments, for example, they may be detected by an infrared sensor different from the camera.

While the cameras or the camera is fixed to the conveyor in the first to third embodiments, for example, it may be fixed to a section different from the conveyor.

While four cameras are fixedly mounted on the conveyor in the above-described first and second embodiments, for example, three cameras may be fixedly mounted. Further, while the center position of the glass substrate is acquired on the basis of the images of the four corner portions taken by the four cameras in the first and second embodiments, it may be acquired on the basis of images of three corner portions taken by three cameras.

While the portions of the sheet-like member protruding from the glass substrate are trimmed in the above-described first to third embodiments, portions of the glass substrate to be detected may be photographed (detected) for processing different from trimming.

While the glass substrate (substrate) is held by suction in the first to third embodiments, it may be held by other methods.

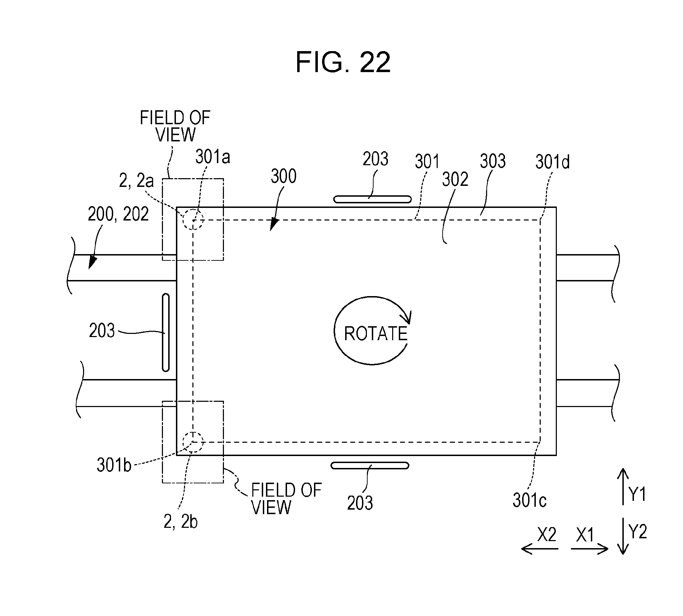

While one camera is provided on the conveyor in the third embodiment, for example, two cameras may be provided on a side of arrow X2 of the conveyor, as in a modification illustrated in Fig. 22. In this case, two corner portions 301a and 301b of four corner portions of a substantially rectangular glass substrate 301 are photographed by cameras 2a and 2b in a state in which the glass substrate 301 is located at a reference position. Further, corner portions 301c and 301d to be detected are photographed by the cameras 2a and 2b by rotating the glass substrate 301 180 degrees while holding the substrate 300 (glass substrate 301) by an end effecter 13 of a robot arm 12.

## Claims

1. A robot system (100) comprising:
a detector (2) that is fixedly provided to detect a detected portion of a workpiece;
a robot arm (12) equipped with a holder (13) that holds the workpiece; and
a workpiece detection control unit (14a) that performs control such that, when a detected portion of a second workpiece (310) having a size different from a reference size of a first workpiece (300), in the workpiece, is detected, the detected portion of the second workpiece (310) is detected by the detector (2) in a state in which the second workpiece (310) is held and shifted by the holder (13) of the robot arm (12).

2. The robot system according to Claim 1,
wherein the workpiece detection control unit is configured such that the detected portion of the second workpiece is detected by the detector in a state in which the second workpiece is held and shifted from a reference position in a horizontal direction by the holder of the robot arm.

3. The robot system according to Claim 1 or 2,
wherein the detector includes a first detector part and a second detector part,
wherein the detected portion of the workpiece includes a first detected portion and a second detected portion, and
wherein the workpiece detection control unit is configured such that, when the detected portion of the second workpiece is detected, the first detected portion of the second workpiece is detected by the first detector part in a state in which the second workpiece is located at the reference position, and the second detected portion of the second workpiece is detected by the second detector part in a state in which the second workpiece is held and shifted from the reference position by the holder of the robot arm.

4. The robot system according to Claim 3,
wherein the workpiece detection control unit is configured such that, when the detected portion of the first workpiece is detected, the first detected portion and the second detected portion of the first workpiece are detected by the first detector part and the second detector part in a state in which the first workpiece is held and moved to the reference position by the holder of the robot arm, and such that, when the detected portion of the second workpiece is detected, the first detected portion of the second workpiece is detected by the first detector part in a state in which the second workpiece is held and moved to the reference position by the holder of the robot arm, and the second detected portion of the second workpiece is detected by the second detector part in a state in which the second workpiece is shifted from the reference position while the second workpiece is kept held by the holder of the robot arm.

5. The robot system according to any one of Claims 1 to 4,
wherein the detector is fixedly provided at a position a predetermined distance below a position on a conveyor where the workpiece is placed.

6. The robot system according to any one of Claims 1 to 5,
wherein the workpiece detection control unit acquires a center position of the workpiece on the basis of a detection result of the detected portion of the workpiece detected by the detector, and
wherein the robot system further comprises:
a workpiece transport instruction unit that performs control such that the workpiece is transported to a workpiece processing position on the basis of a displacement amount between the acquired center position of the workpiece and a portion on the workpiece corresponding to a center position of the holder of the robot arm.

7. The robot system according to Claim 6,
wherein the workpiece is covered with a sheet-like member, and
wherein the workpiece transport instruction unit performs control on the basis of the displacement amount between the acquired center position of the workpiece and the position on the workpiece corresponding to the center position of the holder of the robot arm such that the workpiece is transported to a trimming position where a portion of the sheet-like member protruding from the workpiece is trimmed.

8. The robot system according to Claim 6 or 7,
wherein, after the workpiece is held by the holder of the robot arm, in a state in which the workpiece is kept held, the movement of the workpiece to the reference position and the detection of the detected portion of the workpiece are performed by the workpiece detection control unit, and the transport of the workpiece to the workpiece processing position on the basis of the detection result of the detected portion of the workpiece detected by the detector is performed by the workpiece transport instruction unit.

9. The robot system according to any one of Claims 1 to 8, further comprising:
a storage unit that prestores sizes of the first workpiece and the second workpiece,
wherein the workpiece detection control unit is configured such that the detected portion of the second workpiece is detected by the detector in a state in which the second workpiece is held and shifted from a reference position by a predetermined horizontal distance in a horizontal direction by the holder of the robot arm on the basis of the size of the second workpiece prestored in the storage unit.

10. The robot system according to any one of Claims 1 to 9,
wherein the first workpiece and the second workpiece each have a rectangular shape to have four corner portions,
wherein the detector includes a first detector part located at a position corresponding to the corner portion on one side of the rectangular workpiece and a second detector part located at a position corresponding to the corner portion on the other side, and
wherein the workpiece detection control unit is configured such that, when the detected portion of the first workpiece is detected, the four corner portions of the first workpiece are detected by the first detector part and the second detector part in a state in which the first workpiece is placed at a reference position and such that, when the detected portion of the second workpiece is detected, two of the four corner portions of the second workpiece are detected by the first detector part in a state in which the second workpiece is placed at the reference position and two remaining corner portions of the second workpiece are detected by the second detector part in a state in which the second workpiece is held and shifted from the reference position by the holder of the robot arm.

11. The robot system according to Claim 1 or 2,
wherein the workpiece has a rectangular shape to have four corner portions,
wherein at least one detector is provided at a position corresponding to the corner portion on one side of the rectangular workpiece, and
wherein the workpiece detection control unit is configured such that any of the four corner portions of the rectangular workpiece is detected by the detector in a state in which the workpiece is placed at a reference position and such that the remaining corner portions of the workpiece are detected by the detector by holding and sequentially moving the workpiece by the holder of the robot arm to positions where the remaining corner portions are detected by the detector.

12. An article manufacturing method comprising:
transporting a workpiece; and
detecting, by a detector (2), a detected portion of a second workpiece (310) having a size different from a reference size of a first workpiece (300), of the transported workpiece, in a state in which the second workpiece (310) is held and shifted by a holder (13) of a robot arm (12).
